# EUROPEAN PATENT APPLICATION

(11) **EP 0 715 357 A1**
(43) Date of publication of application: **05.06.1996**
(21) Application number: 95118551.1
(22) Date of filing: 24.11.1995
(51) Int. Cl.: H01L 29/207

(54) **Carbon-doped GaAsSb semiconductor**

(30) Priority: 30.11.1994 US 348264
(71) Applicant: ROCKWELL INTERNATIONAL CORPORATION, Seal Beach, California 90740-8250 (US)
(72) Inventor: McDermott, Brian T., Thousand Oaks, CA 91360 (US)
(74) Representative: Wächtershäuser, Günter, Prof. Dr.

(57) **Abstract**

A p-type semiconductor is formed of carbon-doped gallium arsenide antimonide (GaAsSb:C). Carbon-doped GaAsSb can be fabricated by metalorganic chemical vapor deposition (MOCVD) using source materials such as triethylgallium or trimethylgallium for Ga; tertiarybutylarsine, trimethylarsenic, or arsine for As; trimethylantimony, triethylantimony, or stibane for Sb; and carbon tetrachloride, carbon tetrabromide, trimethylgallium, or trimethylarsenic for C. Molecular beam epitaxy (MBE) or metalorganic MBE (MOMBE) can utilize the foregoing sources in addition to traditional MBE sources such as elemental Ga, As, and Sb. Carbon-doped GaAsSb comprises a p-type semiconductor that may replace conventional p-type GaInAs in InP-based semiconductor devices where high concentrations of a low diffusivity p-type dopant must be incorporated without hydrogen passivation effects. If desired, active carbon concentrations in excess of 1x10²⁰ cm⁻³ can be achieved in GaAsSb. Thus, high hole concentration can be provided in a p-type semiconductor that is compatible with InP-based semiconductor materials.

## Description

### Technical Field

The present invention relates to III-V semiconductor materials and, in particular, to carbon-doped GaAsSb, which is compatible with InP-based semiconductor materials and may be used to form a highly doped p-type region in electronic devices.

### Background of the Invention

High speed electronic devices, such as heterojunction bipolar transistors (HBTs) fabricated from III-V semiconductor materials, generally require highly doped p-type semiconductor regions. At high concentrations, however, most p-type dopants tend to diffuse into other regions of a multilayer device. Unwanted diffusion of dopants results in poor device performance, including unstable and unreliable operation.

For GaAs-based semiconductor devices, carbon is known to be an effective p-type dopant that does not exhibit significant diffusion. Carbon doping has lead to reliable operation of GaAs semiconductor devices with regions having high hole concentrations (e.g., ≧ 10¹⁹cm⁻³).

For semiconductor devices based on InP substrates, the traditional low bandgap material of choice has been GaInAs. However, p-type doping of GaInAs, whether by metalorganic chemical vapor deposition (MOCVD) or molecular beam epitaxy (MBE), has been challenging for crystal growers. MOCVD can be used for doping GaInAs with zinc, but the highest concentration attainable is in the low 10¹⁹cm⁻³ range. Unfortunately, zinc can diffuse very rapidly, and the reliability of devices with high zinc doping is not known. MBE can be used for doping GaInAs with beryllium, but the diffusivity of Be is also relatively high. Typically, a thick spacer layer is required to alleviate diffusion-related deterioration in devices having Be-doped regions.

GaInAs can be doped with carbon using both MOCVD and MBE growth techniques to form a p-type semiconductor material. However, carbon-doped GaInAs (GaInAs:C), especially when grown by MOCVD, exhibits hydrogen passivation that significantly reduces the viable hole concentration. This hydrogen passivation effect is enhanced by the amount of indium in the material-GaInAs with low indium content shows good carbon-doping characteristics, nearly identical to GaAs. Unfortunately, when lattice-matched to InP-based materials, GaInAs:C has an indium content of approximately 53% and is subject to hydrogen passivation effects. If the layer of GaInAs:C is an exposed surface, the passivation effects can be reversed by annealing in a nitrogen atmosphere at temperatures ≧ 400°C. For devices such as HBTs, however, where the carbon-doped p⁺ active base layer is buried (i.e., is not an exposed surface), re-activation by annealing in nitrogen is not a viable technique.

In view of the foregoing limitations of the prior art, there is a need for a low-bandgap semiconductor material that is compatible with InP-based materials and can be carbon-doped in concentrations up to approximately 10²⁰cm⁻³ without significant hydrogen passivation effects. It is also desirable that such a carbon-doped semiconductor material be producible by both MOCVD and MBE processes.

### Summary of the Invention

The present invention comprises a semiconductor formed of carbon-doped gallium arsenide antimonide (GaAsSb:C). Carbon-doped GaAsSb can be fabricated by metalorganic chemical vapor deposition (MOCVD) or molecular beam epitaxy (MBE), for example, to produce a p-type semiconductor. GaAsSb:C has been grown by MOCVD using triethylgallium (TEGa), tertiarybutylarsine (TBAs), trimethylantimony (TMSb), and carbon tetrachloride (CCl₄) as the source materials for gallium, arsenic, antimony, and carbon, respectively. Other source materials such as trimethylgallium for Ga; arsine or trimethylarsenic for As; stibane or triethylantimony for Sb; and carbon tetrabromide, trimethylgallium, or trimethylarsenic for C may also be used in combination to produce carbon-doped GaAsSb by MOCVD. It is anticipated that MBE or metalorganic MBE (MOMBE) can utilize the foregoing sources in addition to traditional MBE sources such as elemental Ga, As, and Sb.

Carbon-doped GaAsSb comprises a p-type semiconductor that may replace conventional p-type GaInAs in InP-based semiconductor devices where high concentrations of a low diffusivity p-dopant must be incorporated in a region of the device without hydrogen passivation effects. Active carbon concentrations in excess of 1x10²⁰ cm⁻³ can be achieved in GaAsSb if desired.

A principal object of the invention is a p-type semiconductor that is compatible with InP-based semiconductor materials. A feature of the invention is carbon-doped GaAsSb. An advantage of the invention is high hole concentration in a p-type semiconductor that is compatible with InP-based semiconductor materials and can be produced using MOCVD and MBE processes.

### Brief Description of the Drawings

For a more complete understanding of the present invention and for further advantages thereof, the following Detailed Description of the Preferred Embodiments makes reference to the accompanying Drawings, in which:

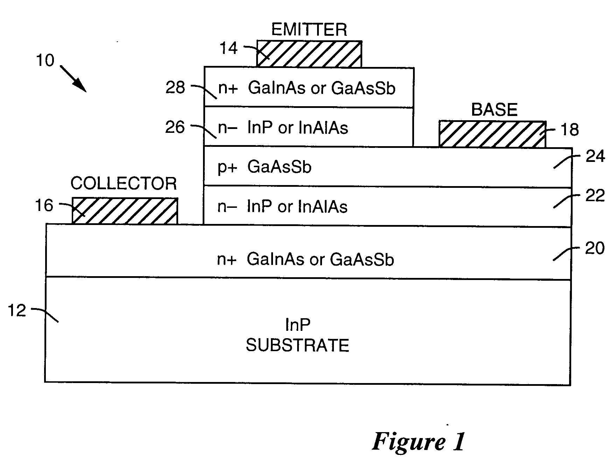

FIGURE 1 is a schematic cross section of an exemplary InP-based semiconductor device incorporating a region of carbon-doped GaAsSb of the present invention.

### Detailed Description of the Preferred Embodiments

The present invention comprises a p-type semiconductor formed of carbon-doped gallium arsenide antimonide (GaAsSb:C). Carbon-doped GaAsSb can be fabricated by various methods, such as metalorganic chemical vapor deposition (MOCVD) or molecular beam epitaxy (MBE), for example. GaAsSb:C has been grown by MOCVD using triethylgallium (TEGa), tertiarybutylarsine (TBAs), trimethylantimony (TMSb), and carbon tetrachioride (CCl₄) as the source materials for gallium, arsenic, antimony, and carbon, respectively. The growth conditions used in a horizontal MOCVD chamber were in the temperature range of 500-600°C and 70 torr operating pressure. These materials and conditions were selected based on previous experience in the growth of InP-based heterojunction bipolar transistors (HBTs) by MOCVD. Other source materials such as trimethylgallium for Ga; arsine or trimethylarsenic for As; stibane or triethylantimony for Sb; and carbon tetrabromide, trimethylgallium, or trimethylarsenic for C may also be used in combination to produce carbon-doped GaAsSb by MOCVD. It is anticipated that MBE or metalorganic MBE (MOMBE) can utilize the foregoing sources in addition to traditional MBE sources such as elemental Ga, As, and Sb.

Using MOCVD, careful control of the As/Sb ratio in the gas phase is required to achieve a GaAsSb composition that is compatible with InP. Since arsenic deposits preferentially over antimony, a larger gas phase concentration of TMSb is generally needed. The addition of CCl₄ can cause a lower growth rate and change in the composition relative to undoped or n-type doped GaAsSb material. Upon the addition of CCl₄, the GaAsSb composition skews toward As-rich, requiring a reduction in the TBAs gas phase concentration to maintain the correct composition.

### InP-Based Semiconductor Devices

InP-based semiconductor materials comprise a family of related materials that may be grown epitaxially on an InP substrate. InP-based materials generally include InP, GaₓIn₁₋ₓAs, GaₓIn₁₋ₓAs_{y}P_{1-y}, AlₓIn₁₋ₓAs, GaAsₓSb₁₋ₓ, GaₓIn₁₋ₓAs_{y}Sb_{1-y}, AlAsₓSb₁₋ₓ, GaPₓSb₁₋ₓ, and AlₓGa₁₋ₓAs_{y}Sb_{1-y}. The ternary and quaternary InP-based materials can be grown such that their compositions result in crystal structures having a lattice parameter matching that of InP (i.e., lattice matched materials). These compositions, however, can also be fabricated with lattice parameters that differ significantly from that of InP.

Carbon-doped GaAsSb comprises a p-type semiconductor that may replace conventional p-type GaInAs in InP-based semiconductor devices where high concentrations of a low diffusivity p-dopant must be incorporated without hydrogen passivation effects. If desired, active carbon concentrations in excess of 1x10²⁰ cm⁻³ can be achieved in GaAsSb.

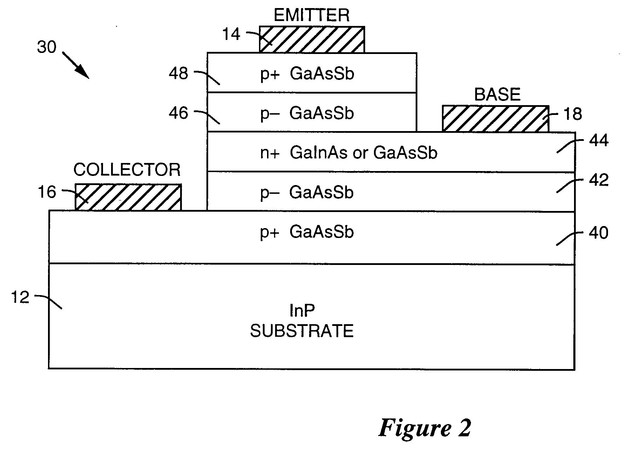

Carbon-doped GaAsSb is useful, for example, as a p-type layer in III-V compound semiconductor HBTs, which may comprise n-p-n or p-n-p devices as is well known in the art. As examples, an n-p-n HBT 10 is illustrated in schematic cross section in Figure 1 and an alternative p-n-p HBT 30 is illustrated in Figure 2. HBTs 10 and 30 are formed on an InP substrate 12 and include contacts 14, 16, and 18 for an emitter, a collector, and a base, respectively. In n-p-n HBT 10, which is described and illustrated as an exemplary embodiment (not a limitation), a collector contact (subcollector) layer 20, a collector layer 22, a base layer 24, an emitter layer 26, and an emitter contact layer 28 are deposited epitaxially on InP substrate 12 as illustrated in Figure 1. Emitter layer 16 and collector layer 22 may comprise lightly doped (n⁻) InP or InAlAs, for example. Contact layers 20 and 28 may comprise heavily doped (n⁺) GaInAs or GaAsSb, for example. Heavily doped base layer 24 (p⁺) is fabricated from carbon-doped GaAsSb of the present invention, which replaces p-type GaInAs that is used in the prior art. By replacing p⁺ GaInAs of the prior art with carbon-doped p⁺ GaAsSb of the present invention, high concentrations of a low diffusivity p-type dopant can be incorporated without hydrogen passivation effects. Base layer 24 may be fabricated of GaAsSb:C using the MOCVD growth techniques described above, as well as other crystal growth techniques such as MBE and MOMBE.

An advantage of the present invention is that InP-based semiconductor devices can be fabricated using well-known MOCVD techniques, achieving active carbon concentrations in GaAsSb in excess of 1x10²⁰ cm⁻³ if desired. Because the active base layer in an HBT, for example, is a buried junction, bounded above and below by the emitter and collector, respectively, nitrogen-ambient annealing as used to reverse hydrogen passivation effects in an exposed, prior art GaInAs:C layer is not an effective technique. Thus, carbon-doped GaAsSb of the present invention is a superior semiconductor material for InP-based HBTs, especially when fabrication by established MOCVD techniques is desired.

## Claims

1. An InP-based semiconductor, comprising:
a layer (12, 20, 22) of InP-based semiconductor material; and
an epitaxial layer (24, 42) of carbon-doped GaAsSb deposited atop said layer (12, 20, 22) of InP-based material.

2. The InP-based semiconductor of Claim 1, wherein said layer of InP-based semiconductor material comprises an InP substrate (12) and said carbon-doped GaAsSb is deposited as an epitaxial layer (24, 42) on said InP substrate (12).

3. The InP-based semiconductor of Claim 1, further comprising:
an InP substrate (12);
said layer of InP-based semiconductor material deposited as an epitaxial layer (20, 22, 42) on said InP substrate (12); and
said carbon-doped GaAsSb deposited as an epitaxial layer (24, 44) on said layer of InP-based semiconductor material (20, 22, 42).

4. The InP-based semiconductor of Claim 1, further comprising:
an InP substrate (12);
a first layer (20, 22) of n-type InP-based semiconductor material deposited on said InP substrate (12);
said carbon-doped GaAsSb deposited as a p-type layer (24) on said first layer (20, 22) of n-type InP-based semiconductor material; and
a second layer (26) of n-type InP-based semiconductor material deposited on said p-type layer (24) of carbon-doped GaAsSb.

5. The InP-based semiconductor of Claim 1, wherein said layer (12, 20, 22, 42) of InP-based semiconductor material is selected from the group of materials consisting of InP, GaₓIn₁₋ₓAs, GaₓIn₁₋ₓAs_{y}P_{1-y}, AlₓIn₁₋ₓAs, GaAsₓSb₁₋ₓ, GaₓIn₁₋ₓAs_{y}Sb_{1-y}, AlAsₓSb₁₋ₓ, GaPₓSb₁₋ₓ, and AlₓGa₁₋ₓAs_{y}Sb_{1-y}.

6. The InP-based semiconductor of Claim 1, further comprising:
an InP substrate (12);
said layer of InP-based semiconductor material deposited as a first n⁺ epitaxial layer (20) on said InP substrate (12);
a first n⁻ epitaxial layer (22) of InP-based semiconductor material deposited on said first n⁺ layer (20);
said carbon-doped GaAsSb deposited as a p⁺ epitaxial layer (24) on said first n⁻ layer (22);
a second n⁻ epitaxial layer (26) of InP-based semiconductor material deposited on said p⁺ layer (24) of carbon-doped GaAsSb; and
a second n⁺ epitaxial layer (28) of InP-based semiconductor material deposited on said second n⁻ layer (26).

7. The InP-based semiconductor of Claim 1, wherein the semiconductor is an n-p-n HBT device (10) comprising:
an InP substrate (12);
said layer of InP-based semiconductor material deposited as an n⁺ collector contact layer (20) on said InP substrate (12);
a collector layer (22) of n⁻ InP-based semiconductor material deposited on said n⁺ collector contact layer (20);
said carbon-doped GaAsSb deposited as a p⁺ base layer (24) on said n⁻ collector layer (22);
an emitter layer (26) of n⁻ InP-based semiconductor material deposited on said p⁺ base layer (24) of carbon-doped GaAsSb; and
an emitter contact layer (28) of n⁺ InP-based semiconductor material deposited on said n⁻ emitter layer (26).

8. The InP-based semiconductor of Claim 1, wherein the semiconductor is a p-n-p HBT device (30) comprising:
an InP substrate (12);
said carbon-doped GaAsSb deposited as a p⁺ collector contact layer (40) on said InP substrate (12);
said layer of InP-based semiconductor material deposited as a p⁻ collector (42) layer on said p⁺ collector contact layer (40);
a base layer (44) of n⁺ InP-based semiconductor material deposited on said p⁻ collector layer (42);
an emitter layer (46) of p⁻ InP-based semiconductor material deposited on said n⁺ base layer (44); and
an emitter contact layer (48) of p⁺ InP-based semiconductor material deposited on said p⁻ emitter layer (46).

9. The p-n-p HBT (30) of Claim 8, wherein said collector layer (42) comprises a p⁻ carbon-doped GaAsSb layer.

10. The p-n-p HBT (30) of Claim 9, wherein said emitter contact layer (48) comprises a p⁺ carbon-doped GaAsSb layer.
